(19) Europäisches Patentamt
European Patent Office
Office européen des brevets

(11) **EP 4 394 412 B1**

(12) **EUROPEAN PATENT SPECIFICATION**

(45) Date of publication and mention
of the grant of the patent:
**01.10.2025 Bulletin 2025/40**

(21) Application number: **22861034.1**

(22) Date of filing: **26.07.2022**

(51) International Patent Classification (IPC):
*G01R 31/392* (2019.01)    *H01M 10/48* (2006.01)
*H02J 7/00* (2006.01)

(52) Cooperative Patent Classification (CPC):
**G01R 31/392; H01M 10/48; H02J 7/005;**
G01R 31/396; Y02E 60/10

(86) International application number:
**PCT/JP2022/028688**

(87) International publication number:
**WO 2023/026743 (02.03.2023 Gazette 2023/09)**

(54) **DETERIORATION DETERMINATION SYSTEM, DETERIORATION DETERMINATION METHOD, AND DETERIORATION DETERMINATION PROGRAM**

VERSCHLECHTERUNGSBESTIMMUNGSSYSTEM, VERSCHLECHTERUNGSBESTIMMUNGSVERFAHREN UND VERSCHLECHTERUNGSBESTIMMUNGSPROGRAMM

SYSTÈME DE DÉTERMINATION DE DÉTÉRIORATION, PROCÉDÉ DE DÉTERMINATION DE DÉTÉRIORATION ET PROGRAMME DE DÉTERMINATION DE DÉTÉRIORATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.08.2021 JP 2021135551**

(43) Date of publication of application:
**03.07.2024 Bulletin 2024/27**

(73) Proprietor: **Panasonic Intellectual Property Management Co., Ltd.**
**Kadoma-shi, Osaka 571-0057 (JP)**

(72) Inventor: **ISHII, Yohei**
**Kadoma-shi, Osaka 571-0057 (JP)**

(74) Representative: **Novagraaf International SA**
**Chemin de l'Echo 3**
**1213 Onex, Geneva (CH)**

(56) References cited:
WO-A1-2019/054020    WO-A1-2019/171688
WO-A1-2020/218184    CN-A- 110 456 275
CN-A- 112 327 191    JP-A- 2019 203 841
JP-A- 2020 180 935    JP-B2- 6 531 836
US-A1- 2020 408 842

## Description

Technical Field

The present disclosure relates to a deterioration determination system, a deterioration determination method, and a deterioration determination program for determining sudden battery deterioration.

Background Art

In recent years, hybrid vehicles (HVs), plug-in hybrid vehicles (PHVs), and electric vehicles (EVs) have become popular. In these electric motor vehicles, secondary batteries such as lithium-ion batteries are mounted as a key device.

When secondary batteries such as lithium-ion batteries are repeatedly charged and discharged at low temperature or at a high rate, a sudden drop in capacity (hereinafter referred to as sudden deterioration or tertiary degradation) becomes more likely due to a decrease in an electrolyte solution, a reduction in the reactive area of an electrode plate, or the like. The sudden deterioration of a secondary battery mounted on an electric motor vehicle eventually leads to a sudden reduction in the distance the electric motor vehicle can travel, resulting in reduced convenience.

The timing for replacement of a secondary battery for vehicles is typically set on the basis of a state of health (SOH). This is also the case for a secondary battery for uses other than vehicles (for example, a secondary battery used for stationary power storage systems). When sudden deterioration occurs in a secondary battery, the SOH decreases to a reference value at which replacement is required, at a rate higher than expected by users, managers, etc. Therefore, when sudden deterioration occurs, the timing for replacement is likely to come in the state where preparation for the replacement has not been made.

Furthermore, the secondary battery becomes prone to internal short-circuiting due to deposition after the sudden deterioration occurs. Thus, after the sudden deterioration occurs, early replacement is necessary from the perspective of safety.

Proposed methods for detecting sudden deterioration of a secondary battery include a method for extracting, in a narrow time window, SOH data that is entered in time series, calculating a linear approximation, and detecting sudden deterioration on the basis of a change in the slope of the calculated approximate straight line (for example, refer to Patent Literature (PTL) 1).

Citation List

Patent Literature

PTL 1: International Publication No. 17/098686
PTL 2: JP 6 531836 B2
PTL 2 Discloses a deterioration determination system comprising:

a battery capacity calculator that obtains battery data of a secondary battery;
a maintenance rate calculator that identifies a state of health (SOH) of the secondary battery on the basis of the battery data;
a linear regression analyzer that generates a deterioration regression curve of the secondary battery by performing curve regression on a plurality of states of health of the secondary battery that have been identified in time series;
a rapid deterioration determiner that determines sudden deterioration of the secondary battery on the basis of the slope ratio.

Summary of Invention

The values of a state of charge (SOC), full charge capacity (FCC), and the SOH calculated on the basis of voltage and electric current measurement data of a secondary battery are affected by sensor measurement errors, noise, etc. If the effects of the errors, noise, etc., are significant, the value of the slope of the approximate straight line is unstable. Furthermore, it is difficult to set, to an appropriate value, a threshold value for detecting sudden deterioration from the slope of the approximate straight line.

The present disclosure is conceived in view of this situation and has an object to provide a technique to accurately determine sudden deterioration of a secondary battery.

In order to solve the above problem, a deterioration determination system according to one aspect of the present disclosure includes: a data obtainment unit that obtains battery data; a SOH identification unit that identifies a state of health (SOH) of the secondary battery on the basis of the battery data; a regression curve generation unit that generates a deterioration regression curve of the secondary battery by performing curve regression on a plurality of SOHs of the secondary battery that have been identified in time series; a reference point setting unit that sets a reference point on the deterioration regression curve; a regression line generation unit that generates a deterioration regression line of the secondary battery by performing linear regression on the plurality of SOHs obtained after the reference point, the deterioration regression line following the reference point; a slope ratio calculation unit that calculates a slope ratio between a slope of a tangent line to the deterioration regression curve at the reference point and a slope of the deterioration regression line following the reference point; and a sudden deterioration determination unit that determines sudden deterioration of the secondary battery on the basis of the slope ratio.

Note that an arbitrary combination of the structural elements described above and those obtained by converting the expressions described in the present disclosure into devices, systems, methods, computer programs, and recording media having the computer programs recorded thereon, for example, are also effective as embodiments of the present disclosure.

With the present disclosure, sudden deterioration of a secondary battery can be accurately determined.

Brief Description of Drawings

[Fig. 1] Fig. 1 is a diagram for describing a deterioration determination system according to an exemplary embodiment.
[Fig. 2] Fig. 2 is a diagram for describing main elements of an electric motor vehicle and a battery pack.
[Fig. 3] Fig. 3 is a diagram illustrating an example configuration of a deterioration determination system according to an exemplary embodiment.
[Fig. 4] Fig. 4 is a diagram for describing a method for estimating FCC.
[Fig. 5] Fig. 5 is a diagram illustrating one example of SOH time-series data of one secondary battery.
[Fig. 6] Fig. 6 is a diagram illustrating one example of a deterioration regression curve, a tangent line, and a deterioration regression line when sudden deterioration does not occur.
[Fig. 7] Fig. 7 is a diagram illustrating one example of a deterioration regression curve, a tangent line, and a deterioration regression line when sudden deterioration occurs.
[Fig. 8] Fig. 8 is a diagram illustrating one example in which a deterioration regression curve is generated on the basis of a SOH actual measurement value of a cell included in a battery pack mounted on one electric motor vehicle.
[Fig. 9] Fig. 9 is a diagram for describing the process of searching for a predicted start point of sudden deterioration (No. 1).
[Fig. 10] Fig. 10 is a diagram for describing the process of searching for a predicted start point of sudden deterioration (No. 2).
[Fig. 11] Fig. 11 is a diagram illustrating a specific example of a sudden deterioration determination method according to a comparative example.
[Fig. 12] Fig. 12 is a diagram illustrating a specific example of a sudden deterioration determination method according to an exemplary embodiment.
[Fig. 13] Fig. 13 is a flowchart illustrating the flow of a first processing example of a sudden deterioration determination method according to an exemplary embodiment.
[Fig. 14] Fig. 14 is a flowchart illustrating the flow of a second processing example of a sudden deterioration determination method according to an exemplary embodiment.

Description of Embodiments

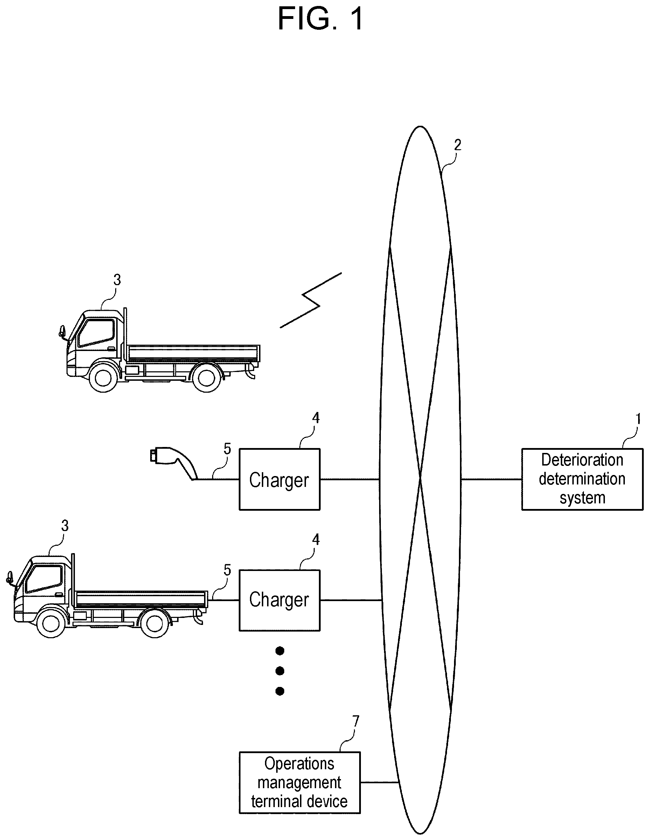

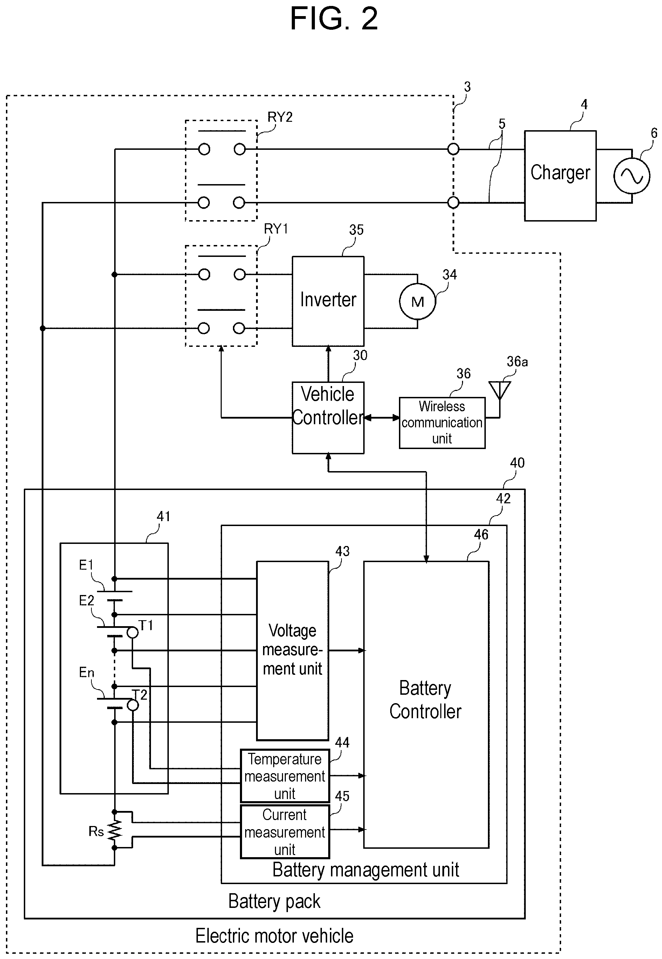

Fig. 1 is a diagram for describing deterioration determination system 1 according to an exemplary embodiment. Deterioration determination system 1 according to an exemplary embodiment is a system for determining whether sudden deterioration has occurred in battery pack 40 (refer to Fig. 2) mounted on electric motor vehicle 3. Fig. 1 shows an example in which a delivery operator uses deterioration determination system 1. Deterioration determination system 1 may be constructed on a company server installed in a data center or a company facility of a service providing entity that provides an operations management support service for electric motor vehicles 3, for example. Alternatively, deterioration determination system 1 may be constructed on a cloud server that is used in accordance with a cloud service contract. Furthermore, deterioration determination system 1 may be constructed on two or more servers geographically dispersed and installed at two or more locations (including a data center and a company facility). The two or more servers may be any of a combination of two or more company servers, a combination of two or more cloud servers, and a combination of a company server and a cloud server.

Each delivery operator owns a plurality of electric motor vehicles 3 and at least one charger 4 and has a distribution center for parking the plurality of electric motor vehicles 3. Electric motor vehicle 3 is connected to charger 4 with charging cable 5, and battery pack 40 mounted on electric motor vehicle 3 is charged from charger 4 through charging cable 5.

Operations management terminal device 7 is placed in the distribution center of the delivery operator. Operations management terminal device 7 includes a personal computer (PC), for example. Operations management terminal device 7 is used to manage the plurality of electric motor vehicles 3 belonging to the distribution center. Using operations management terminal device 7, an operations manager for the delivery operator can create a delivery plan, a charging plane, and the like for the plurality of electric motor vehicles 3. Operations management terminal device 7 is capable of accessing deterioration determination system 1 via network 2.

Network 2 is a generic term of communication paths such as the Internet, a dedicated line, and a virtual private network (VPN); the communication medium, the protocol, etc., of network 2 are not limited. As the communication medium, a mobile network (cellular network), a wireless local area network (LAN), a wired LAN, a fiber optic network, an asymmetric digital subscriber line (ADSL) network, or a cable television (CATV) network can be used, for example. As the communication protocol, transmission control protocol (TCP)/Internet protocol (IP), user datagram protocol (UDP)/IP, or Ethernet (registered trademark) can be used, for example.

Fig. 2 is a diagram for describing main elements of electric motor vehicle 3 and battery pack 40. Battery pack 40 is connected to motor 34 via first relay RY1 and inverter 35. Inverter 35 converts direct-current power supplied from battery pack 40 into alternating-current power and supplies the alternating-current power to motor 34 during power running. During regeneration, the alternating-current power supplied from motor 34 is converted into direct-current power and supplied to battery pack 40. Motor 34, which is a three-phase alternating-current motor, rotates according to the alternating-current power supplied from inverter 35 during power running. During regeneration, rotational energy generated as a result of a reduction in speed is converted into alternating-current power and supplied to inverter 35.

First relay RY1 is a contactor that is inserted between lines that connect battery pack 40 and inverter 35. During a travel period, vehicle controller 30 performs control such that first relay RY1 is ON (closed), electrically connecting battery pack 40 and a power system of electric motor vehicle 3 to each other. During a non-travel period, vehicle controller 30 performs control such that first relay RY1 is OFF (open) in principle, electrically disconnecting battery pack 40 and the power system of electric motor vehicle 3 from each other. Note that instead of the relay, other types of switches such as a semiconductor switch may be used.

Battery pack 40 can be charged from commercially available electric power system 6 when connected with charging cable 5 to charger 4 placed outside electric motor vehicle 3. Charger 4 is connected to commercially available electric power system 6 and charges battery pack 40 in electric motor vehicle 3 through charging cable 5. In electric motor vehicle 3, second relay RY2 is inserted between lines that connect battery pack 40 and charger 4. Note that instead of the relay, other types of switches such as a semiconductor switch may be used. Battery management unit 42 of battery pack 40 performs control such that second relay RY2 is ON before the start of charging, and performs control such that second relay RY2 is OFF after the end of charging.

Generally, alternating-current power is used in the case of normal charging, and direct-current power is used in the case of fast charging. When alternating-current power is used for charging, an onboard charger (not illustrated in the drawings) that is inserted between second relay RY2 and battery pack 40 converts the alternating-current power into direct-current power.

Battery pack 40 includes battery module 41 and battery management unit 42, and battery module 41 includes a plurality of cells E1 to En connected in series. Note that battery module 41 may be configured of a plurality of battery modules connected in series or series/parallel. As the cells, lithium-ion battery cells, nickel-hydrogen battery cells, lead battery cells, or the like can be used. The following example herein assumes that lithium-ion battery cells (with a nominal voltage of 3.6 V to 3.7 V) are used. The number of cells E1 to En connected in series is determined according to a drive voltage for motor 34.

Shunt resistor Rs is connected in series to the plurality of cells E1 to En. Shunt resistor Rs functions as an electric current detection element. Note that a Hall element may be used instead of shunt resistor Rs. Furthermore, a plurality of temperature sensors T1, T2 for measuring the temperatures of the plurality of cells E1 to En are provided in battery module 41. One temperature sensor may be provided for the battery module or may be provided for each set of cells. As temperature sensors T1, T2, thermistors can be used, for example.

Battery management unit 42 includes voltage measurement unit 43, temperature measurement unit 44, current measurement unit 45, and battery controller 46. A plurality of voltage lines are connected between voltage measurement unit 43 and the respective nodes of the plurality of cells E1 to En connected in series. Voltage measurement unit 43 measures the voltage of each of cells E1 to En by measuring a voltage between two adjacent voltage lines. Voltage measurement unit 43 transmits the measured voltage of each of cells E1 to En to battery controller 46.

Voltage measurement unit 43 and battery controller 46 are connected by a communication line in the state where these are insulated from each other because voltage measurement unit 43 is at a higher voltage than battery controller 46. Voltage measurement unit 43 can be configured using an application specific integrated circuit (ASIC) or a general-purpose analog front end IC. Voltage measurement unit 43 includes a multiplexer and an A/D converter. The multiplexer outputs the voltage between two adjacent voltage lines to the A/D converter in descending order. The A/D converter converts, into a digital value, an analog voltage that is input from the multiplexer.

Temperature measurement unit 44 includes a voltage-dividing resistor and an A/D converter. The A/D converter sequentially converts, into digital values, the plurality of analog voltages divided by the plurality of voltage-dividing resistors and the plurality of temperature sensors T1, T2, and outputs the digital values to battery controller 46. Battery controller 46 estimates the temperatures of the plurality of cells E1 to En on the basis of said digital values. For example, battery controller 46 estimates the temperatures of cells E1 to En on the basis of measurement values of the temperature sensor that is most adjacent to cells E1 to En.

Current measurement unit 45 includes a differential amplifier and an A/D converter. The differential amplifier amplifies a voltage between both ends of shunt resistor Rs and outputs the voltage to the A/D converter. The A/D converter converts, into a digital value, a voltage that is input from the differential amplifier, and outputs the digital value to battery controller 46. Battery controller 46 estimates, on the basis of said digital value, an electric current flowing to the plurality of cells E1 to En.

Note that when an A/D converter is provided in battery controller 46 and battery controller 46 includes an analog input port, temperature measurement unit 44 and current measurement unit 45 may output the analog voltages to battery controller 46, and the A/D converter included in battery controller 46 may convert the analog voltages into digital values.

Battery controller 46 (also referred to as a battery management unit (BMU) or a battery management system (BMS)) includes a microcontroller, a communication controller, and non-volatile memory. Battery controller 46 and vehicle controller 30 are connected via an in-vehicle network (that is a controller area network (CAN) or a local interconnect network (LIN), for example). The communication controller controls the communication with vehicle controller 30.

Battery controller 46 manages the states of the plurality of cells E1 to En on the basis of the voltages, temperatures, and electric currents at the plurality of cells E1 to En that have been measured by voltage measurement unit 43, temperature measurement unit 44, and current measurement unit 45.

Battery controller 46 estimates the SOC of each of the plurality of cells E1 to En included in battery module 41. Battery controller 46 estimates the SOC by a combination of the open circuit voltage (OCV) method and the current integration method. The OCV method is a method for estimating a SOC on the basis of the OCV of a cell and the SOC-OCV curve of the cell. The SOC-OCV curve of the cell is created in advance on the basis of a property test conducted by a battery manufacturer and is registered in internal memory of the microcontroller at the time of shipment.

The current integration method is a method for estimating a SOC on the basis of the OCV of a cell measured at the start of charging or discharging and the integrated value of electric currents flowing to the cell. In the current integration method, errors of electric current measurement are accumulated as charging or discharging time increases. Therefore, it is preferable that using the SOC estimated by the OCV method, the SOC estimated by the current integration method be corrected.

Battery controller 46 transmits the voltage, the electric current, the temperature, and the SOC of battery module 41 and each of cells E1 to En to vehicle controller 30 via the in-vehicle network.

Vehicle controller 30 is a vehicle electronic control unit (ECU) that controls entire electric motor vehicle 3 and may include an integrated vehicle control module (VCM), for example. Vehicle controller 30 includes: a communication controller for connection to the in-vehicle network; and a communication controller (for example, a CAN controller) for communicating with charger 4 through charging cable 5.

Wireless communication unit 36 performs signal processing for wireless connection to network 2 via antenna 36a. As a wireless communication network to which electric motor vehicle 3 can be wirelessly connected, a mobile network (cellular network), a wireless LAN, vehicle-to-infrastructure (V2I), vehicle-to-vehicle (V2V), an electronic toll collection system (ETC system), dedicated short range communications (DSRC), or the like can be used, for example.

Vehicle controller 30 can transmit travel data including battery data to deterioration determination system 1 in real time using wireless communication unit 36 during travel of electric motor vehicle 3. The travel data includes at least the speed of electric motor vehicle 3. The battery data includes the voltage, the electric current, the temperature, and the SOC of each of the plurality of cells E1 to En. Vehicle controller 30 samples the data regularly (for example, at intervals of 10 seconds) and transmits the sampled data to deterioration determination system 1 accordingly.

Note that vehicle controller 30 may accumulate the travel data of electric motor vehicle 3 in internal memory and transmit the collection of travel data accumulated in the memory at a predetermined timing. For example, vehicle controller 30 may transmit the collection of travel data accumulated in the memory to operations management terminal device 7 after the close of business day. Operations management terminal device 7 transmits the travel data of the plurality of electric motor vehicles 3 to deterioration determination system 1 at a predetermined timing.

Furthermore, at the time of charging from charger 4 that includes a network communication function, vehicle controller 30 may transmit the collection of travel data accumulated in the memory to charger 4 through charging cable 5.

Charger 4 transmits the received travel data to deterioration determination system 1. This example is effective when charger 4 includes a network communication function and electric motor vehicle 3 does not include a wireless communication function.

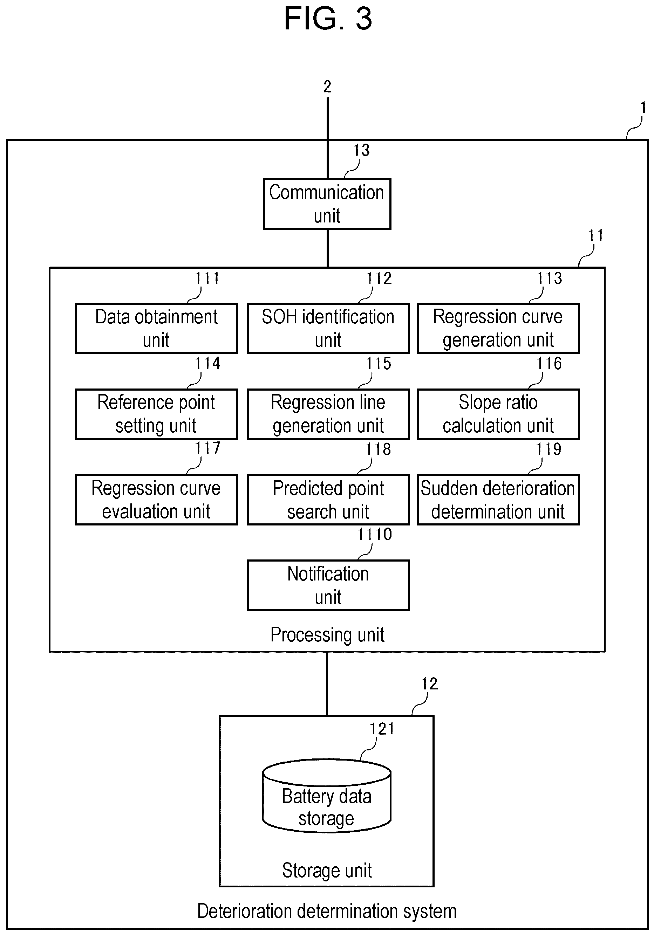

Fig. 3 is a diagram for describing an example configuration of deterioration determination system 1 according to the exemplary embodiment. Deterioration determination system 1 includes processing unit 11, storage unit 12, and communication unit 13. Communication unit 13 includes a communication interface (for example, a router) for wired or wireless connection to network 2.

Processing unit 11 includes data obtainment unit 111, SOH identification unit 112, regression curve generation unit 113, reference point setting unit 114, regression line generation unit 115, slope ratio calculation unit 116, regression curve evaluation unit 117, predicted point search unit 118, sudden deterioration determination unit 119, and notification unit 1110. The functions of processing unit 11 can be implemented by the coordination of a hardware resource and a software resource or can be implemented by a hardware resource only. As the hardware resource, a central processing unit (CPU), read-only memory (ROM), random-access memory (RAM), a graphics processing unit (GPU), an application specific integrated circuit (ASIC), a field programmable gate array (FPGA), and other LSI can be used. As the software resource, an operating system and a program such as an application can be used.

Storage unit 12 includes battery data storage 121. Storage unit 12 includes a non-volatile recording medium such as a hard disk drive (HDD) and a solid-state drive (SSD) and stores various data.

Data obtainment unit 111 obtains, via network 2, travel data (including battery data) of electric motor vehicle 3 that is traveling or battery data of electric motor vehicle 3 that is parked, and stores the obtained battery data into battery data storage 121. The travel data other than the battery data may be stored into battery data storage 121 together or may be stored into another travel data storage (not illustrated in the drawings).

At a predetermined timing, SOH identification unit 112 reads the battery data of battery pack 40 mounted on electric motor vehicle 3 that is stored in battery data storage 121, and calculates the SOH of each of cells E1 to En included in battery pack 40. The predetermined timing may be a point in time when charging of electric motor vehicle 3 from charger 4 is completed or may be a point in time when electric motor vehicle 3 starts traveling for the first time after completion of charging.

On the basis of SOC and voltages (OCV) of each of cells E1 to En measured at two points (both of which are included in a parking period) and included in the battery data, SOH identification unit 112 estimates FCC of each of cells E1 to En, and estimates a SOH on the basis of the FCC estimated.

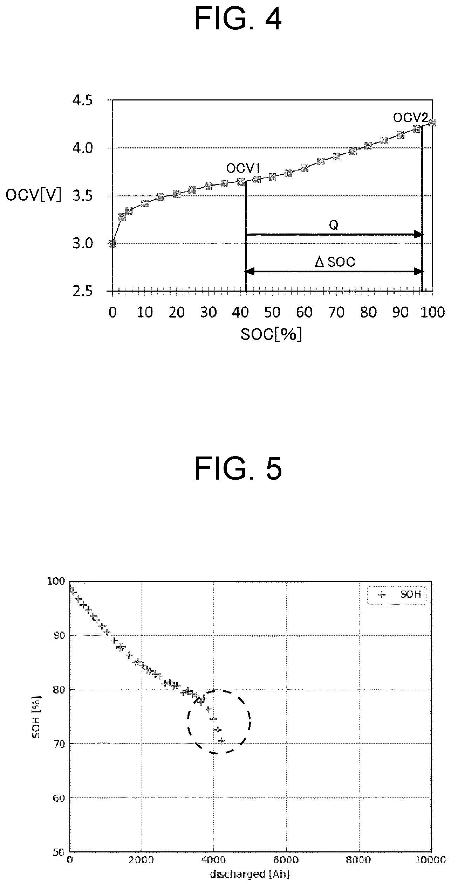

Fig. 4 is a diagram for describing a method for estimating FCC. SOH identification unit 112 calculates a difference ($\Delta$SOC) between SOC corresponding to OCV1 before the start of charging and SOC corresponding to OCV2 after the end of charging. SOH identification unit 112 calculates electric current integrated value Q by integrating electric currents obtained from the start to the end of charging.

SOH identification unit 112 estimates FCC by calculating the following (Expression 1), and estimates a SOH by calculating the following (Expression 2) on the basis of the FCC estimated. The SOH is defined by the ratio of the current FCC to the initial FCC; a SOH with a lower numerical value (closer to 0%) indicates more advanced deterioration.

$$FCC = Q \, / \, \Delta SOC \, ... \, \text{(Expression 1)}$$

$$SOH = \text{Current FCC} \, / \, \text{Initial FCC} \, ... \, \text{(Expression 2)}$$

Note that FCC can also be estimated on the basis of OCV1 before the start of travel of electric motor vehicle 3 and OCV2 after the end of travel of electric motor vehicle 3.

SOH identification unit 112 stores, into battery data storage 121, the SOH of each of cells E1 to En that has been estimated. Note that the SOH and the FCC of each of cells E1 to En may be estimated in battery controller 46 of electric motor vehicle 3. When the FCC and the SOH estimated in battery controller 46 are included in the battery data transmitted from electric motor vehicle 3 to deterioration determination system 1, deterioration determination system 1 does not need to estimate the FCC and the SOH.

Regression curve generation unit 113 reads, from battery data storage 121, the whole data of the SOHs of target cells included target battery pack 40 that have been identified in time series, and generates a deterioration regression curve of the target cells by performing curve regression on the plurality of SOHs that have been read. For the curve regression, the method of least squares can be used, for example.

Fig. 5 is a diagram illustrating one example of SOH time-series data of one secondary battery. The horizontal axis represents total discharge capacity [Ah], and the vertical axis represents SOH [%]. It is known that cell deterioration progresses in proportion to the square root of the total discharge capacity or time (the square-root law or the one-half power law), as indicated in the following (Expression 3).

$$SOH = w_0 + w_1\sqrt{t} \text{ ... (Expression 3)}$$

In the expression , $w_0$ is an initial value, and $w_1$ is a deterioration coefficient.

Regression curve generation unit 113 determines deterioration coefficient $w_1$ for the above (Expression 3) according to one-half power exponential curve regression where the total discharge capacity or time is an independent variable and SOH is a dependent variable. Here, $w_0$ is common and is typically set in the range of 1.0 to 1.1. When there is a match between the actual initial capacity and the nominal value, $w_0$ is set equal to 1.0 and the nominal value is set to the guaranteed minimum amount, and when the nominal value is set less than the actual initial capacity, $w_0$ is set to a value greater than 1.0.

As illustrated in Fig. 5, when sudden deterioration occurs in a secondary battery, the speed of deterioration changes (increases) from deterioration that follows the square-root law to linear deterioration. In the present exemplary embodiment, the occurrence of sudden deterioration is detected by the following processes.

Reference point setting unit 114 sets reference point A on the deterioration regression curve generated by regression curve generation unit 113. Reference point setting unit 114 sets reference point A to a point on the deterioration regression curve that is located earlier by a predetermined value than the end of a data segment of the plurality of SOHs identified in time series. For example, reference point setting unit 114 may set reference point A to a point on the deterioration regression curve obtained on a date that is n days (for example, 30 days, 60 days, or 90 days) before the latest time. Alternatively, reference point setting unit 114 may set reference point A to a point on the deterioration regression curve that corresponds to the total discharge capacity measured earlier by $\alpha$ [Ah] than the latest total discharge capacity.

Furthermore, reference point setting unit 114 may set reference point A to a point on the deterioration regression curve that corresponds to the time or the total discharge capacity at a data point located n points (for example, 50 points) before the latest data. Note that reference point setting unit 114 may use, as data corresponding to the data point located n points before the latest data, data located at a position at which the whole data segment is divided at a predetermined proportion (3:1).

By performing linear regression on the plurality of SOHs obtained after reference point A set by reference point setting unit 114, regression line generation unit 115 generates a deterioration regression line of the target cell that follows reference point A. For the linear regression, the method of least squares can be used, for example.

It is empirically known that sudden cell deterioration tends to be linearly approximated with respect to the total discharge capacity or time, as indicated in the following (Expression 4).

$$SOH = aT + b \text{ ... (Expression 4)}$$

Here, a is the speed of deterioration after the start of sudden deterioration, and b is the SOH at the start of sudden deterioration.

Slope ratio calculation unit 116 calculates the ratio (a/a_tan) between slope a_tan of the tangent line to the deterioration regression curve at reference point A and slope a of the deterioration regression line based on the plurality of SOHs obtained after reference point A. Slope a_tan of the tangent line to the deterioration regression curve at reference point A can be calculated from the derivative at reference point A.

Sudden deterioration determination unit 119 determines sudden deterioration of the target cell on the basis of the slope ratio (a/a_tan) calculated by slope ratio calculation unit 116. For example, when the slope ratio (a/a_tan) exceeds threshold value th as indicated in the following (Expression 5), sudden deterioration determination unit 119 determines that sudden deterioration has occurred in the target cell.

$$a/a\_tan > th \text{ ... (Expression 5)}$$

Threshold value th can be set in consideration of the results of an experiment, simulation, or the like and the knowledge of a designer. The tangent line to the deterioration regression curve at reference point A and the deterioration regression line reflect a predicted value of the speed of deterioration at reference point A. For example, when threshold value th is set to 2, this means that it is determined whether the predicted value of the speed of deterioration has increased at least two-fold at the time of reference point A.

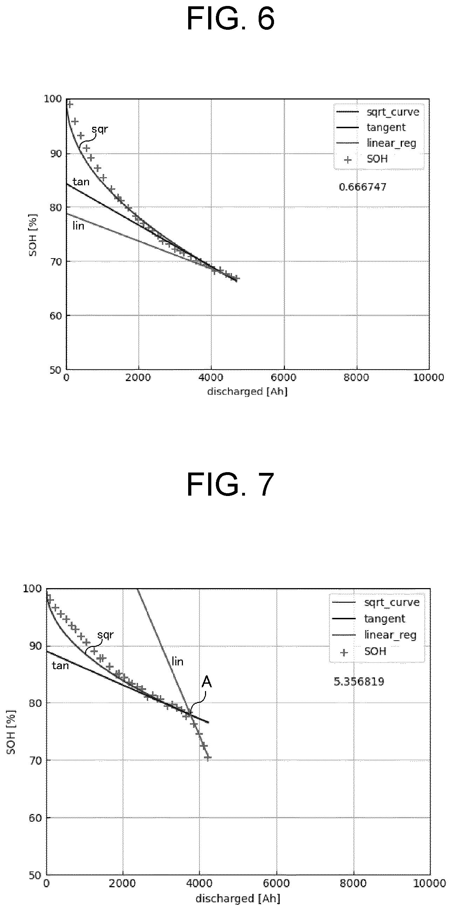

Fig. 6 is a diagram illustrating one example of deterioration regression curve sqr, tangent line tan, and deterioration regression line lin when sudden deterioration does not occur. Fig. 7 is a diagram illustrating one example of deterioration regression curve sqr, tangent line tan, and deterioration regression line lin when sudden deterioration occurs. The slope ratio (a/a_tan) is 0.666747 in the example illustrated in Fig. 6, and the slope ratio (a/a_tan) is 5.356819 in the example illustrated in Fig. 7. In the example illustrated in Fig. 7, the slope ratio (a/a_tan) is greater than 2, and thus it is determined that sudden deterioration has occurred.

Note that in the above examples, the slope ratios is set to the ratio (a/a_tan) of slope a of the deterioration regression line to slope a_tan of the tangent line to the deterioration regression curve at reference point A, but may be set to the ratio (a_tan/a) of slope a_tan of the tangent line to the deterioration regression curve at reference point A to slope a of the deterioration regression line. In this case, when the slope ratio (a_tan/a) is less than threshold value th (for example, 0.5), sudden deterioration determination unit 119 determines that sudden deterioration has occurred in the target cell.

On the basis of the relationship between the deterioration regression curve generated by regression curve generation unit 113 and the plurality of SOHs serving as basic data for said deterioration regression curve, regression curve evaluation unit 117 evaluates the dependability of said deterioration regression curve. Regression curve evaluation unit 117 can use a commonly used index such as a residual sum of squares, a residual standard deviation, a coefficient of determination, or a coefficient of correlation as an index indicating the dependability of a regression curve. The residual sum of squares and the residual standard deviation increase as variations in the SOH increase. The coefficient of determination and the coefficient of correlation indicate the relationship between a temporal element and the SOH. When the dependability of the basic data (SOH) is low, the dependability of the deterioration regression curve is also low.

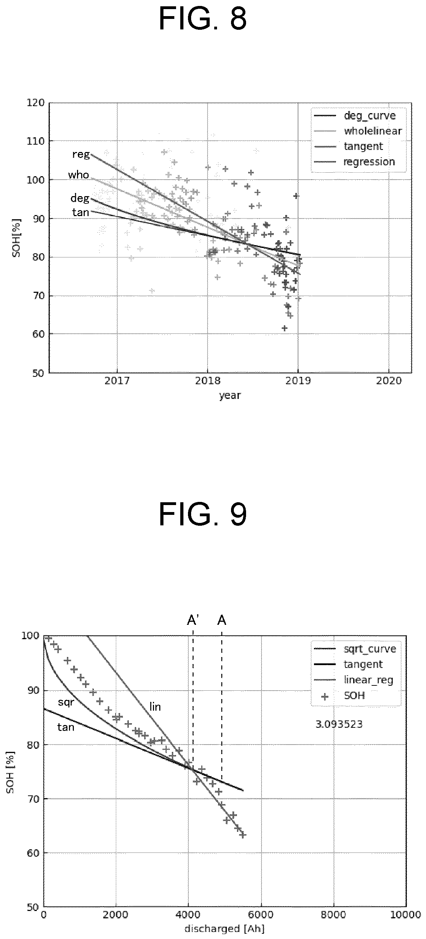

Fig. 8 is a diagram illustrating one example in which deterioration regression curve deg is generated on the basis of a SOH actual measurement value of a cell included in battery pack 40 mounted on one electric motor vehicle 3. In the example illustrated in Fig. 8, the reference point is set to the point of intersection between deterioration regression curve deg and deterioration regression line who with respect to the whole SOH data, and deterioration regression line reg based on SOHs obtained after said reference point is generated under the condition of passing through said reference point.

In the example illustrated in Fig. 8, a large amount of SOH sampling data is plotted above the upper limit of deterioration regression curve deg, and there are significant variations in the sampling data. In sudden deterioration determination using a deterioration regression curve based on such sampling data, the likelihood of erroneous determination is high.

When the dependability of the deterioration regression curve does not meet a set condition (for example, when the residual sum of squares is greater than a set value), sudden deterioration determination unit 119 discards the deterioration regression curve and avoids determining sudden deterioration.

In the above description, reference point A is directly used as a fixed value; however, optimal reference point A may be searched for. Predicted point search unit 118 causes reference point A to dynamically change and searches for a predicted start point of sudden cell deterioration.

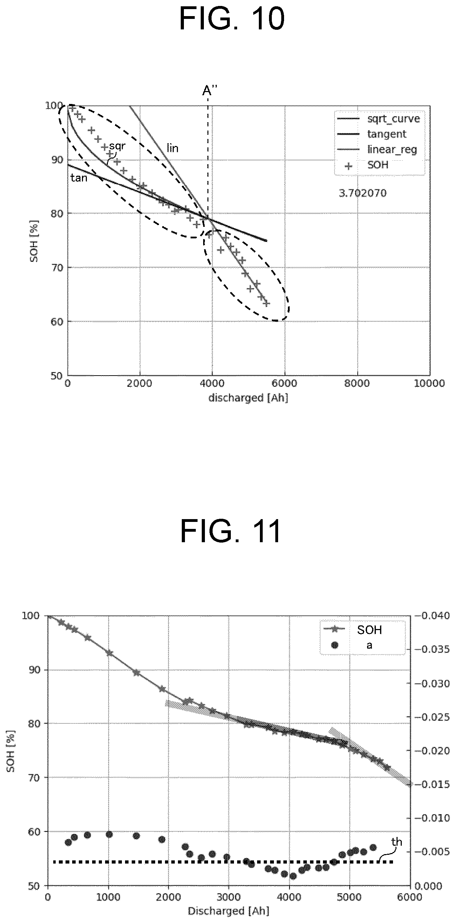

Fig. 9 is a diagram for describing the process of searching for a predicted start point of sudden deterioration (No. 1). Fig. 10 is a diagram for describing the process of searching for a predicted start point of sudden deterioration (No. 2). First, regression curve generation unit 113 generates a deterioration regression curve of a target cell on the basis of the whole SOH data of the target cell. Reference point setting unit 114 determines reference point A as described above, and sets reference point A to a tentative reference point (an initial value). Regression line generation unit 115 generates a deterioration regression line on the basis of the plurality of SOHs obtained after tentative reference point A.

As illustrated in Fig. 9, predicted point search unit 118 sets new reference point A' to the point of intersection between the generated deterioration regression curve and the generated deterioration regression line. Regression curve generation unit 113 generates a new deterioration regression curve on the basis of a plurality of SOHs obtained before new reference point A, and regression line generation unit 115 generates a new deterioration regression line on the basis of a plurality of SOHs obtained after new reference point A'.

Predicted point search unit 118 sets new reference point A" to the point of intersection between the generated new deterioration regression curve and the generated new deterioration regression line. As illustrated in Fig. 10, regression curve generation unit 113 generates a new deterioration regression curve on the basis of a plurality of SOHs obtained before new reference point A", and regression line generation unit 115 generates a new deterioration regression line on the basis of a plurality of SOHs obtained after new reference point A". This processing will be repeated.

Predicted point search unit 118 sets the predicted start point of sudden deterioration to a point of convergence of repeatedly updated reference point A. For example, when the distance between not-yet-updated reference point A and updated reference point A is less than a set value, predicted point search unit 118 may determine that reference point A has converged. Furthermore, when the aforementioned process of updating reference point A is performed a set number of times, predicted point search unit 118 may assume that reference point A has converged. When the dependability of the generated new deterioration regression curve meets a determination criterion (for example, when the residual sum of squares between the deterioration regression curve and a plurality of SOHs is less than a set value), predicted point search unit 118 may determine that reference point A has converged. When the dependability of the generated new deterioration regression curve meets the determination criterion and the dependability of the generated new deterioration regression line meets a determination criterion (for example, when the residual sum of squares between the deterioration regression line and a plurality of SOHs is less than a set value), predicted point search unit 118 may determine that reference point A has converged.

Furthermore, by shifting reference point A using a brute-force approach, regression curve generation unit 113 and regression line generation unit 115 may generate a deterioration regression curve and a deterioration regression line, and predicted point search unit 118 may set the predicted start point of sudden deterioration to reference point A at which the deterioration regression curve and the deterioration regression line have the highest dependability.

Slope ratio calculation unit 116 calculates the aforementioned slope ratio (a/a_tan) at the predicted start point of sudden deterioration that has been set, and sudden deterioration determination unit 119 determines sudden deterioration of a target cell on the basis of the calculated slope ratio (a/a_tan).

Predicted point search unit 118 may set a search exclusion range in searching for a predicted start point of sudden deterioration. For example, predicted point search unit 118 may set the search exclusion range to a range where the SOH is greater than or equal to a predetermined value (for example, 80%), a range where the total discharge capacity of the cell is less than or equal to a set value (for example, 4,000 Ah), or a range where the period of use of the cell is less than or equal to a set value (for example, two years). Note that reference point setting unit 114 does not set reference point A in the search exclusion range.

Notification unit 1110 issues, to electric motor vehicle 3 with battery pack 40 mounted thereon that includes a cell for which it is determined that sudden deterioration has occurred or operations management terminal device 7 that manages said electric motor vehicle 3, an alert indicating inclusion of the cell in which sudden deterioration has occurred.

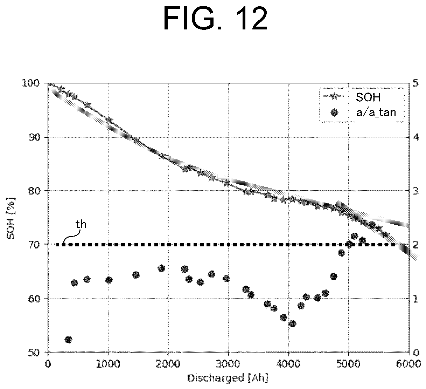

Fig. 11 is a diagram illustrating a specific example of a sudden deterioration determination method according to a comparative example. Fig. 12 is a diagram illustrating a specific example of a sudden deterioration determination method according to the exemplary embodiment. In the comparative example, a regression line is generated on the basis of the most recent n SOHs. In Fig. 11, slopes a of the regression line at respective points in time are plotted.

In the exemplary embodiment, regression line generation unit 115 generates a regression line on the basis of the most recent n SOHs. Regression curve generation unit 113 generates a deterioration regression curve on the basis of the whole SOHs excluding the most recent n SOHs. Slope ratio calculation unit 116 calculates the ratio (a/a_tan) between slope a_tan of the tangent line to the deterioration regression curve at reference point A corresponding to the SOH located n SOHs before and slope a of the deterioration regression line based on the most recent n SOHs. In Fig. 12, the slope ratios (a/a_tan) at respective points in time are plotted. For example, n is set in the range of 3 to 7.

In the comparative example illustrated in Fig. 11, it is difficult to set favorable threshold value th. For example, if threshold value th is set to a small value, when cell deterioration transitions in an almost linear curve, the likelihood increases that sudden deterioration will be erroneously determined to have occurred. Conversely, if threshold value th is set to a large value, sudden deterioration is less likely to be detected even when sudden deterioration occurs in a cell. In contrast, in the exemplary embodiment illustrated in Fig. 12, threshold value th is set to approximately 2, and thus whether sudden deterioration has occurred can be accurately determined.

For each type of cells, changes in the slope ratio (a/a_tan) over time may be learned to generate a model of the occurrence of sudden deterioration. Said model can be generated by machine learning, pattern recognition, or the like. Slope ratio calculation unit 116 calculates a slope ratio (a/a_tan) every time a new SOH is added. When the behavior of the slope ratio (a/a_tan) in time-series data of the slope ratio (a/a_tan) meets a determination condition based on the generated model, sudden deterioration determination unit 119 determines that sudden deterioration has occurred in the target cell.

For example, for a type of cells in which as a learned tendency, the slope ratio (a/a_tan) tends to decrease by at least a predetermined value at no less than a predetermined speed and then increase by at least a predetermined value at no less than a predetermined speed before sudden deterioration occurs, it is possible to detect the sudden deterioration at a prior stage by detecting this behavior of the slope ratio (a/a_tan). The sudden deterioration can be detected at least early on after the occurrence of the sudden deterioration.

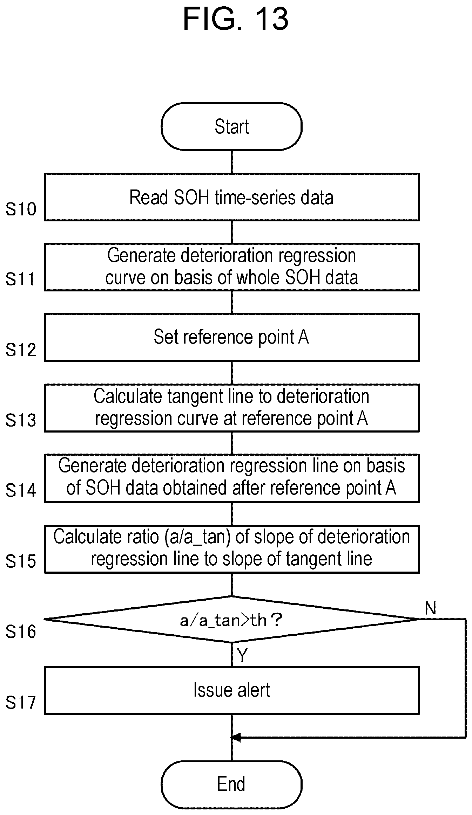

Fig. 13 is a flowchart illustrating the flow of a first processing example of the sudden deterioration determination method according to the exemplary embodiment. Regression curve generation unit 113 reads the whole data of SOHs of the target cell included in target battery pack 40 that have been identified in time series, which is accumulated in battery data storage 121 (S10). Regression curve generation unit 113 generates a deterioration regression curve of the target cell by performing curve regression on the whole data of SOHs that has been read (S11).

Reference point setting unit 114 sets reference point A on the deterioration regression curve (S12). Slope ratio calculation unit 116 calculates the tangent line to the deterioration regression curve at reference point A (S13). By performing linear regression on the plurality of SOHs obtained after reference point A, regression line generation unit 115 generates a deterioration regression line following reference point A (S14). Slope ratio calculation unit 116 calculates the ratio (a/a_tan) between the slope of the tangent line to the deterioration regression curve at reference point A and the slope of the deterioration regression line based on the plurality of SOHs obtained after reference point A (S15).

Sudden deterioration determination unit 119 compares the calculated slope ratio (a/a_tan) and threshold value th (S16). When the slope ratio (a/a_tan) exceeds threshold value th (Y in S16), notification unit 1110 issues, to electric motor vehicle 3 that uses the target cell or operations management terminal device 7 that manages said electric motor vehicle 3, an alert indicating use of the cell in which sudden deterioration has started (S17). When the slope ratio (a/a_tan) is less than or equal to threshold value th (N in S16), said alert is not issued.

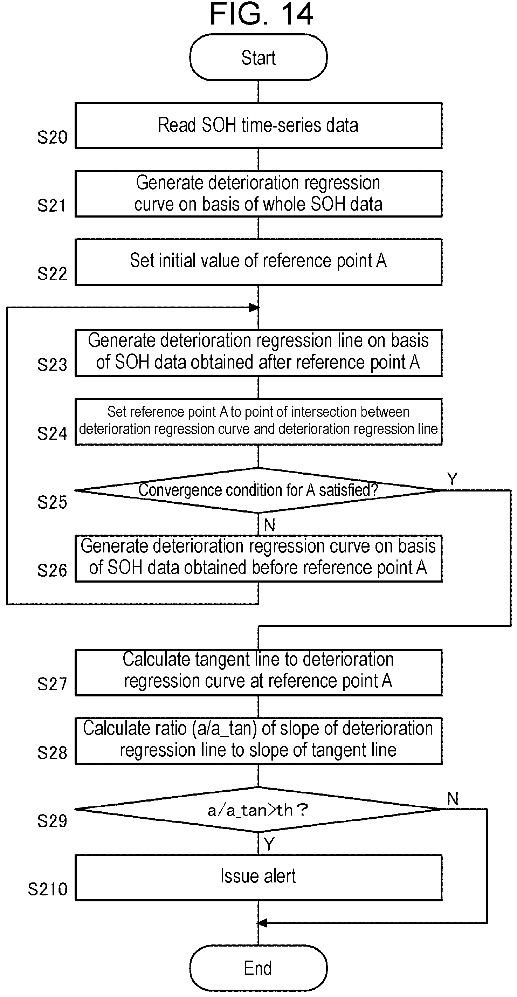

Fig. 14 is a flowchart illustrating the flow of a second processing example of the sudden deterioration determination method according to the exemplary embodiment. Regression curve generation unit 113 reads the whole data of SOHs of the target cell included in target battery pack 40 that have been identified in time series, which is accumulated in battery data storage 121 (S20). Regression curve generation unit 113 generates a deterioration regression curve of the target cell by performing curve regression on the whole data of SOHs that has been read (S21).

Reference point setting unit 114 sets an initial value of reference point A on the deterioration regression curve (S22). By performing linear regression on the plurality of SOHs obtained after most recently set reference point A, regression line generation unit 115 generates a deterioration regression line following reference point A (S23). Predicted point search unit 118 sets new reference point A to the point of intersection between the most recently generated deterioration regression curve and the deterioration regression line following most recently set reference point A (S24).

Predicted point search unit 118 determines whether most recently set reference point A satisfies a convergence condition (S25). When most recently set reference point A does not satisfy the convergence condition (N in S25), regression curve generation unit 113 generates a new deterioration regression curve by performing curve regression on the plurality of SOHs obtained before most recently set reference point A (S26). Subsequently, the processing transitions to Step S23, and reference point A continues to be updated.

When most recently set reference point A satisfies the convergence condition in Step S25 (Y in S25), slope ratio calculation unit 116 calculates the tangent line to the most recently generated deterioration regression curve at most recently set reference point A (S27). Slope ratio calculation unit 116 calculates the ratio (a/a_tan) between the slope of said tangent line and the slope of the deterioration regression line based on the plurality of SOHs obtained after most recently set reference point A (S28).

Sudden deterioration determination unit 119 compares the calculated slope ratio (a/a_tan) and threshold value th (S29). When the slope ratio (a/a_tan) exceeds threshold value th (Y in S29), notification unit 1110 issues, to electric motor vehicle 3 that uses the target cell or operations management terminal device 7 that manages said electric motor vehicle 3, an alert indicating use of the cell in which sudden deterioration has started (S210). When the slope ratio (a/a_tan) is less than or equal to threshold value th (N in S29), said alert is not issued.

Note that in the example illustrated in the flowchart in Fig. 14, first, optimal reference point A (the predicted start point of sudden deterioration) is searched for, and then sudden deterioration is determined. In this regard, optimal reference point A (the predicted start point of sudden deterioration) may be searched for after sudden deterioration is detected. Specifically, in the first search, the process in Step S23 is performed, then the process in Step S28 and the process in Step S29 are performed, and when sudden deterioration is detected, the process in Step S24 and the subsequent processes are performed. In this example, the amount of processing that would be performed when the sudden deterioration has not occurred can be reduced.

As described above, according to the present exemplary embodiment, sudden cell deterioration can be accurately determined. Detecting sudden deterioration allows electric motor vehicle 3 or battery pack 40 to be efficiently replaced. Furthermore, timely replacement can lead to improved safety regarding the use of battery pack 40. Since the likelihood of internal short-circuiting increases after sudden deterioration occurs, early replacement results in improved safety.

Furthermore, the use of the deterioration curve based on the square-root law makes it possible to perform deterioration prediction that is robust against noise, etc., of a measurement system at the time of SOH estimation. After reference point A, a liner regression line can be used to detect sudden short-term deterioration. Since sudden deterioration is determined on the basis of the slope ratio (a/a_tan) between two straight lines obtained by a commonly used regression method, the increase in the amount of calculation can be minimized. Moreover, since the relative ratio with respect to the speed of deterioration on a normal deterioration curve is used as a parameter, threshold value th can be intuitively set.

When the dependability of the generated deterioration regression curve is low, the deterioration regression curve can be discarded, and thus the determination of sudden deterioration based on less dependable SOH data can be avoided. Furthermore, by searching for optimal reference point A, it is possible to accurately estimate a point in time when sudden deterioration started. Moreover, by limiting the search range for optimal reference point A, it is possible to reduce erroneous determination of the occurrence of sudden deterioration in a region where the probability of occurrence of sudden deterioration is low.

The present disclosure has been described thus far based on the exemplary embodiment. The exemplary embodiment is merely an example; a person having ordinary skill in the art will readily appreciate that various variations are possible as a combination of these structural elements and these processes and that these variations are also included in the scope of the present disclosure.

Deterioration determination system 1 described above may be mounted on battery controller 46 inside electric motor vehicle 3. In this case, large capacity memory is needed, but data loss can be reduced.

The above-described exemplary embodiment has assumed that electric motor vehicle 3 is a four-wheel electric vehicle. In this regard, electric motor vehicle 3 may be an electric motorcycle (an electric scooter), an electric bicycle, or an electric kick scooter. Examples of the electric vehicle include not only a standard electric vehicle, but also a low-speed electric vehicle such as a golf cart or a land car. Furthermore, an object on which battery pack 40 is mounted is not limited to electric motor vehicle 3. Examples of the object on which battery pack 40 is mounted include an electric mobile vehicle such as an electric boat or ship, a railroad car, or a multirotor (a drone), a stationary power storage system, and a consumer electronic device (such as a smartphone or a laptop computer).

Note that the exemplary embodiment may be specified according to the following items.

[Item 1] A deterioration determination system (1) including:

a data obtainment unit (111) that obtains battery data;

a SOH identification unit (112) that identifies a state of health (SOH) of the secondary battery (E1) on the basis of the battery data;

a regression curve generation unit (113) that generates a deterioration regression curve of the secondary battery (E1) by performing curve regression on a plurality of SOHs of the secondary battery (E1) that have been identified in time series;

a reference point setting unit (114) that sets a reference point on the deterioration regression curve;

a regression line generation unit (115) that generates a deterioration regression line of the secondary battery (E1) by performing linear regression on the plurality of SOHs obtained after the reference point, the deterioration regression line following the reference point;

a slope ratio calculation unit (116) that calculates a slope ratio between a slope of a tangent line to the deterioration regression curve at the reference point and a slope of the deterioration regression line following the reference point; and

a sudden deterioration determination unit (119) that determines sudden deterioration of the secondary battery (E1) on the basis of the slope ratio.

With this, sudden deterioration of the secondary battery (E1) can be accurately determined.

[Item 2] The deterioration determination system (1) according to item 1, wherein the reference point setting unit (114) sets the reference point to a point on the deterioration regression curve, the point being located earlier by a predetermined value than an end of a data segment of the plurality of SOHs identified in the time series.

With this, when a tentative point of change in the speed of deterioration is set, accurate determination of sudden deterioration can be realized.

[Item 3] The deterioration determination system (1) according to item 1 or 2, further including:

a regression curve evaluation unit (117) that evaluates dependability of the deterioration regression curve on the basis of a relationship between the deterioration regression curve and the plurality of SOHs serving as a basis of the deterioration regression curve, wherein

when the dependability of the deterioration regression curve does not meet a set condition, the sudden deterioration determination unit (119) avoids determining the sudden deterioration of the secondary battery (E1).

With this, the determination of sudden deterioration based on less dependable SOH data can be avoided.

[Item 4] The deterioration determination system (1) according to any one of items 1 to 3, further including:

a predicted point search unit (118) that searches for a predicated start point of the sudden deterioration of the secondary battery (E1) by dynamically changing the reference point, wherein

the sudden deterioration determination unit (119) determines the sudden deterioration of the secondary battery (E1) on the basis of the slope ratio at the predicted start point.

This makes it possible to set a reference point that matches or approximates the start point of sudden deterioration.

[Item 5] The deterioration determination system (1) according to item 4, wherein

the regression curve generation unit (113) generates the deterioration regression curve of the secondary battery (E1) by performing the curve regression on the plurality of SOHs obtained before the reference point among the plurality of SOHs of the secondary battery (E1) that have been identified in the time series, and

the predicted point search unit (118) sets the predicated start point of the sudden deterioration of the secondary battery (E1) to a point of convergence of a point of intersection between the deterioration regression curve based on the plurality of SOHs obtained before the reference point and the deterioration regression line based on the plurality of SOHs obtained after the reference point.

With this, the start point of sudden deterioration to be set as the reference point can be accurately predicted.

[Item 6] The deterioration determination system (5) according to item 5, wherein

the predicted point search unit (118) excludes, from a search range for the predicted start point, a range where the SOH is greater than or equal to a first set value, a range where total discharge capacity of the secondary battery (E1) is less than or equal to a second set value, or a range where a period of use of the secondary battery (E1) is less than or equal to a third set value.

With this, by limiting the search range for the start point of sudden deterioration to be set as a reference point, it is possible to prevent the reference point from being set in a range where the probability of occurrence of sudden deterioration is low.

[Item 7] The deterioration determination system (1) according to any one of items 1 to 5, wherein when a ratio of the slope of the deterioration regression line following the reference point to the slope of the tangent line to the deterioration regression curve at the reference point exceeds a threshold value or when a ratio of the slope of the tangent line to the deterioration regression curve at the reference point to the slope of the deterioration regression line following the reference point falls below a threshold value, the sudden deterioration determination unit (119) determines that the sudden deterioration of the secondary battery (E1) has occurred.

With this, it is possible to accurately determine sudden deterioration by determining whether the rate of change in the speed of deterioration has increased.

[Item 8] The deterioration determination system (1) according to any one of items 1 to 5, wherein when behavior of the slope ratio in time-series data of the slope ratio meets a determination condition generated on the basis of learning, the sudden deterioration determination unit (119) determines that the sudden deterioration of the secondary battery (E1) or a precursory event to the sudden deterioration has occurred.

This makes it possible to detect sudden deterioration before or immediately after the occurrence of the sudden deterioration.

[Item 9] A deterioration determination method including:

obtaining battery data;
identifying a state of health (SOH) of the secondary battery (E1) on the basis of the battery data;
generating a deterioration regression curve of the secondary battery (E1) by performing curve regression on a plurality of SOHs of the secondary battery (E1) that have been identified in time series;
setting a reference point on the deterioration regression curve;
generating a deterioration regression line of the secondary battery (E1) by performing linear regression on the plurality of SOHs obtained after the reference point, the deterioration regression line following the reference point;
calculating a slope ratio between a slope of a tangent line to the deterioration regression curve at the reference point and a slope of the deterioration regression line following the reference point; and
determining sudden deterioration of the secondary battery (E1) on the basis of the slope ratio.

With this, sudden deterioration of the secondary battery (E1) can be accurately determined.

[Item 10] A deterioration determination program that causes a computer to execute the processes of:

obtaining battery data;
identifying a state of health (SOH) of the secondary battery (E1) on the basis of the secondary battery data;
generating a deterioration regression curve of the secondary battery (E1) by performing curve regression on a plurality of SOHs of the secondary battery (E1) that have been identified in time series;
setting a reference point on the deterioration regression curve;
generating a deterioration regression line of the secondary battery (E1) by performing linear regression on the plurality of SOHs obtained after the reference point, the deterioration regression line following the reference point;
calculating a slope ratio between a slope of a tangent line to the deterioration regression curve at the reference point and a slope of the deterioration regression line following the reference point; and
determining sudden deterioration of the secondary battery (E1) on the basis of the slope ratio.

With this, sudden deterioration of the secondary battery (E1) can be accurately determined.

Reference Signs List

1       deterioration determination system

2            network
3            electric motor vehicle

| | |
|---|---|
| 4 | charger |
| 5 | charging cable |
| 6 | commercially available electric power system |
| 7 | operations management terminal device |
| 11 | processing unit |
| 111 | data obtainment unit |
| 112 | SOH identification unit |
| 113 | regression curve generation unit |
| 114 | reference point setting unit |
| 115 | regression line generation unit |
| 116 | slope ratio calculation unit |
| 117 | regression curve evaluation unit |
| 118 | predicted point search unit |
| 119 | sudden deterioration determination unit |
| 1110 | notification unit |
| 12 | storage unit |
| 121 | battery data storage |
| 13 | communication unit |
| 30 | vehicle controller |
| 34 | motor |
| 35 | inverter |
| 36 | wireless communication unit |
| 36a | antenna |
| 40 | battery pack |
| 41 | battery module |
| 42 | battery management unit |
| 43 | voltage measurement unit |
| 44 | temperature measurement unit |
| 45 | current measurement unit |
| 46 | battery controller |
| E1-En | cell |
| T1-T2 | temperature sensor |
| RY1-RY2 | relay |

## Claims

1. A deterioration determination system comprising:

   a data obtainment unit that obtains battery data of a secondary battery;
   an SOH identification unit that identifies a state of health (SOH) of the secondary battery on the basis of the battery data;
   a regression curve generation unit that generates a deterioration regression curve of the secondary battery by performing curve regression on a plurality of state of healths of the secondary battery that have been identified in time series;
   a reference point setting unit that sets a reference point on the deterioration regression curve;
   a regression line generation unit that generates a deterioration regression line of the secondary battery by performing linear regression on the plurality of SOHs obtained after the reference point, the deterioration regression line following the reference point;
   a slope ratio calculation unit that calculates a slope ratio between a slope of a tangent line to the deterioration regression curve at the reference point and a slope of the deterioration regression line following the reference point; and
   a sudden deterioration determination unit that determines sudden deterioration of the secondary battery on the basis of the slope ratio.

2. The deterioration determination system according to claim 1, wherein
   the reference point setting unit sets the reference point to a point on the deterioration regression curve, the point being located earlier by a predetermined value than an end of a data segment of the plurality of state of healths identified in the time series.

3. The deterioration determination system according to claim 1 or 2, further comprising:

a regression curve evaluation unit that evaluates dependability of the deterioration regression curve on the basis of a relationship between the deterioration regression curve and the plurality of state of healths serving as a basis of the deterioration regression curve, wherein

when the dependability of the deterioration regression curve does not meet a set condition, the sudden deterioration determination unit avoids determining the sudden deterioration of the secondary battery.

4. The deterioration determination system according to any one of claims 1 to 3, further comprising:

a predicted point search unit that searches for a predicated start point of the sudden deterioration of the secondary battery by dynamically changing the reference point, wherein

the sudden deterioration determination unit determines the sudden deterioration of the secondary battery on the basis of the slope ratio at the predicted start point.

5. The deterioration determination system according to claim 4, wherein

the regression curve generation unit generates the deterioration regression curve of the secondary battery by performing the curve regression on the plurality of state of healths obtained before the reference point among the plurality of state of healths of the secondary battery that have been identified in the time series, and

the predicted point search unit sets the predicated start point of the sudden deterioration of the secondary battery to a point of convergence of a point of intersection between the deterioration regression curve based on the plurality of state of healths obtained before the reference point and the deterioration regression line based on the plurality of state of healths obtained after the reference point.

6. The deterioration determination system according to claim 5, wherein

the predicted point search unit excludes, from a search range for the predicted start point, a range where the state of health is greater than or equal to a first set value, a range where total discharge capacity of the secondary battery is less than or equal to a second set value, or a range where a period of use of the secondary battery is less than or equal to a third set value.

7. The deterioration determination system according to any one of claims 1 to 5, wherein

when a ratio of the slope of the deterioration regression line following the reference point to the slope of the tangent line to the deterioration regression curve at the reference point exceeds a threshold value or when a ratio of the slope of the tangent line to the deterioration regression curve at the reference point to the slope of the deterioration regression line following the reference point falls below a threshold value, the sudden deterioration determination unit determines that the sudden deterioration of the secondary battery has occurred.

8. The deterioration determination system according to any one of claims 1 to 5, wherein

when behavior of the slope ratio in time-series data of the slope ratio meets a determination condition generated on the basis of learning, the sudden deterioration determination unit determines that the sudden deterioration of the secondary battery or a precursory event to the sudden deterioration has occurred.

9. A deterioration determination method comprising:

obtaining battery data;

identifying a state of health (SOH) of the secondary battery on the basis of the battery data;

generating a deterioration regression curve of the secondary battery by performing curve regression on a plurality of state of healths of the secondary battery that have been identified in time series;

setting a reference point on the deterioration regression curve;

generating a deterioration regression line of the secondary battery by performing linear regression on the plurality of state of healths obtained after the reference point, the deterioration regression line following the reference point;

calculating a slope ratio between a slope of a tangent line to the deterioration regression curve at the reference point and a slope of the deterioration regression line following the reference point; and

determining sudden deterioration of the secondary battery on the basis of the slope ratio.

10. A non-transitory machine-readable recording medium that stores a deterioration determination program that causes a computer to execute the processes of:

obtaining battery data;

identifying a state of health (SOH) of the secondary battery on the basis of the battery data;

generating a deterioration regression curve of the secondary battery by performing curve regression on a plurality of state of healths of the secondary battery that have been identified in time series;

setting a reference point on the deterioration regression curve;

generating a deterioration regression line of the secondary battery by performing linear regression on the plurality of state of healths obtained after the reference point, the deterioration regression line following the reference point;

calculating a slope ratio between a slope of a tangent line to the deterioration regression curve at the reference point and a slope of the deterioration regression line following the reference point; and

determining sudden deterioration of the secondary battery on the basis of the slope ratio.

**Patentansprüche**

1. System zur Bestimmung einer Verschlechterung, das Folgendes umfasst:

eine Datengewinnungseinheit, die Batteriedaten einer Sekundärbatterie gewinnt;

eine SOH-Identifizierungseinheit, die auf der Grundlage der Batteriedaten einen Gesundheitszustand (state of health, SOH) der Sekundärbatterie identifiziert;

eine Regressionskurven-Erzeugungseinheit, die eine Verschlechterungsregressionskurve der Sekundärbatterie erzeugt, indem sie eine Kurvenregression an einer Vielzahl von Gesundheitszuständen der Sekundärbatterie durchführt, die in Zeitreihen identifiziert worden sind;

eine Bezugspunkt-Festlegungseinheit, die einen Bezugspunkt auf der Verschlechterungsregressionskurve festlegt;

eine Regressionslinien-Erzeugungseinheit, die eine Verschlechterungsregressionslinie der Sekundärbatterie erzeugt, indem sie eine lineare Regression an der Vielzahl von SOHs durchführt, die nach dem Bezugspunkt erhalten wurden, wobei die Verschlechterungsregressionslinie dem Bezugspunkt folgt;

eine Steigungsverhältnis-Berechnungseinheit, die ein Steigungsverhältnis zwischen einer Steigung einer Tangentenlinie an der Verschlechterungsregressionskurve an dem Bezugspunkt und einer Steigung der Verschlechterungsregressionslinie nach dem Bezugspunkt berechnet; und

eine Einheit zur Bestimmung einer plötzlichen Verschlechterung, die eine plötzliche Verschlechterung der Sekundärbatterie auf der Grundlage des Steigungsverhältnisses bestimmt.

2. System zur Bestimmung einer Verschlechterung nach Anspruch 1, wobei die Bezugspunkt-Festlegungseinheit den Bezugspunkt auf einen Punkt auf der Verschlechterungsregressionskurve festlegt, wobei der Punkt um einen vorbestimmten Wert früher liegt als ein Ende eines Datensegments der Vielzahl der in den Zeitreihen identifizierten Gesundheitszustände.

3. System zur Bestimmung einer Verschlechterung nach Anspruch 1 oder 2, das ferner Folgendes umfasst:

eine Regressionskurven-Bewertungseinheit, die die Verlässlichkeit der Verschlechterungsregressionskurve auf der Grundlage einer Beziehung zwischen der Verschlechterungsregressionskurve und der Vielzahl von Gesundheitszuständen, die als Grundlage der Verschlechterungsregressionskurve dienen, bewertet, wobei wenn die Verlässlichkeit der Verschlechterungsregressionskurve eine bestimmte Bedingung nicht erfüllt, die Einheit zur Bestimmung einer plötzlichen Verschlechterung die Bestimmung einer plötzlichen Verschlechterung der Sekundärbatterie vermeidet.

4. System zur Bestimmung einer Verschlechterung nach einem der Ansprüche 1 bis 3, das ferner Folgendes umfasst:

eine Einheit zur Suche nach einem vorhergesagten Punkt, die nach einem vorhergesagten Startpunkt der plötzlichen Verschlechterung der Sekundärbatterie sucht, indem sie den Bezugspunkt dynamisch ändert, wobei die Einheit zur Bestimmung einer plötzlichen Verschlechterung die plötzliche Verschlechterung der Sekundärbatterie auf der Grundlage des Steigungsverhältnisses an dem vorhergesagten Startpunkt bestimmt.

5. System zur Bestimmung einer Verschlechterung nach Anspruch 4, wobei:

eine Regressionskurven-Erzeugungseinheit, die eine Verschlechterungsregressionskurve der Sekundärbatterie erzeugt, indem sie die Kurvenregression an einer Vielzahl von vor dem Bezugspunkt erhaltenen Gesundheitszuständen unter der Vielzahl von Gesundheitszuständen der Sekundärbatterie durchführt, die in den Zeitreihen identifiziert worden sind, und
die Einheit zur Suche nach einem vorhergesagten Punkt den vorhergesagten Startpunkt der plötzlichen Verschlechterung der Sekundärbatterie auf einen Konvergenzpunkt eines Schnittpunkts zwischen der Verschlechterungsregressionskurve, die auf der Vielzahl von vor dem Bezugspunkt erhaltenen Gesundheitszuständen basiert, und der Verschlechterungsregressionslinie, die auf der Vielzahl von nach dem Bezugspunkt erhaltenen Gesundheitszuständen basiert, festlegt.

6. System zur Bestimmung einer Verschlechterung nach Anspruch 5, wobei:
die Einheit zur Suche nach einem vorhergesagten Punkt aus einem Suchbereich für den vorhergesagten Startpunkt einen Bereich ausschließt, in dem der Gesundheitszustand größer oder gleich einem ersten eingestellten Wert ist, einen Bereich ausschließt, in dem die Gesamtentladekapazität der Sekundärbatterie kleiner oder gleich einem zweiten eingestellten Wert ist, oder einen Bereich ausschließt, in dem eine Nutzungsdauer der Sekundärbatterie kleiner oder gleich einem dritten eingestellten Wert ist.

7. System zur Bestimmung einer Verschlechterung nach einem der Ansprüche 1 bis 5, wobei
wenn ein Verhältnis der Steigung der Verschlechterungsregressionslinie nach dem Bezugspunkt zur Steigung der Tangente an der Verschlechterungsregressionskurve am Bezugspunkt einen Schwellenwert überschreitet oder wenn ein Verhältnis der Steigung der Tangente an der Verschlechterungsregressionskurve am Bezugspunkt zur Steigung der Verschlechterungsregressionslinie nach dem Bezugspunkt unter einen Schwellenwert fällt, die Einheit zur Bestimmung einer plötzlichen Verschlechterung bestimmt, dass die plötzliche Verschlechterung der Sekundärbatterie eingetreten ist.

8. System zur Bestimmung einer Verschlechterung nach einem der Ansprüche 1 bis 5, wobei
wenn das Verhalten des Steigungsverhältnisses in den Zeitreihendaten des Steigungsverhältnisses eine Bestimmungsbedingung erfüllt, die basierend auf Lernen erzeugt wird, die Einheit zur Bestimmung einer plötzlichen Verschlechterung bestimmt, dass die plötzliche Verschlechterung der Sekundärbatterie oder ein Vorläuferereignis der plötzlichen Verschlechterung eingetreten ist.

9. Verfahren zur Bestimmung einer Verschlechterung, das Folgendes umfasst:

Gewinnen von Batteriedaten;
Identifizieren eines Gesundheitszustands (state of health, SOH) der Sekundärbatterie auf der Grundlage der Batteriedaten;
Erzeugen einer Verschlechterungsregressionskurve der Sekundärbatterie durch Durchführen einer Kurvenregression an einer Vielzahl von Gesundheitszuständen der Sekundärbatterie, die in Zeitreihen identifiziert worden sind;
Festlegen eines Bezugspunktes auf der Verschlechterungsregressionskurve;
Erzeugen einer Verschlechterungsregressionslinie der Sekundärbatterie durch Durchführen einer linearen Regression an der Vielzahl von Gesundheitszuständen, die nach dem Bezugspunkt erhalten wurden, wobei die Verschlechterungsregressionslinie dem Bezugspunkt folgt;
Berechnen eines Steigungsverhältnisses zwischen einer Steigung einer Tangente an der Verschlechterungsregressionskurve an dem Bezugspunkt und einer Steigung der Verschlechterungsregressionslinie nach dem Bezugspunkt; und
Bestimmen einer plötzlichen Verschlechterung der Sekundärbatterie auf der Grundlage des Steigungsverhältnisses.

10. Nicht-transitorisches maschinenlesbares Aufzeichnungsmedium, das ein Verschlechterungsbestimmungsprogramm speichert, das einen Computer veranlasst, die folgenden Prozesse auszuführen:

Gewinnen von Batteriedaten;
Identifizieren eines Gesundheitszustands (state of health, SOH) der Sekundärbatterie auf der Grundlage der Batteriedaten;
Erzeugen einer Verschlechterungsregressionskurve der Sekundärbatterie durch Durchführen einer Kurvenregression an einer Vielzahl von Gesundheitszuständen der Sekundärbatterie, die in Zeitreihen identifiziert worden sind;

Festlegen eines Bezugspunktes auf der Verschlechterungsregressionskurve;

Erzeugen einer Verschlechterungsregressionslinie der Sekundärbatterie durch Durchführen einer linearen Regression an der Vielzahl von Gesundheitszuständen, die nach dem Bezugspunkt erhalten wurden, wobei die Verschlechterungsregressionslinie dem Bezugspunkt folgt;

Berechnen eines Steigungsverhältnisses zwischen einer Steigung einer Tangente an der Verschlechterungsregressionskurve an dem Bezugspunkt und einer Steigung der Verschlechterungsregressionslinie nach dem Bezugspunkt; und

Bestimmen einer plötzlichen Verschlechterung der Sekundärbatterie auf der Grundlage des Steigungsverhältnisses.

**Revendications**

1. Système de détermination de détérioration comprenant :

une unité d'obtention de données qui obtient des données de batterie d'une batterie secondaire ;

une unité d'identification de SOH qui identifie un état de santé (SOH) de la batterie secondaire sur la base des données de batterie ;

une unité de génération de courbe de régression qui génère une courbe de régression de détérioration de la batterie secondaire par la réalisation d'une régression de courbe sur une pluralité d'états de santé de la batterie secondaire qui ont été identifiés dans une série chronologique ;

une unité de définition de point de référence qui définit un point de référence sur la courbe de régression de détérioration ;

une unité de génération de ligne de régression qui génère une ligne de régression de détérioration de la batterie secondaire par la réalisation d'une régression linéaire sur la pluralité de SOH obtenus après le point de référence, la ligne de régression de détérioration suivant le point de référence ;

une unité de calcul de rapport de pente qui calcule un rapport de pente entre une pente d'une ligne tangente à la courbe de régression de détérioration au point de référence et une pente de la ligne de régression de détérioration suivant le point de référence ; et

une unité de détermination de détérioration soudaine qui détermine une détérioration soudaine de la batterie secondaire sur la base du rapport de pente.

2. Système de détermination de détérioration selon la revendication 1, dans lequel
l'unité de définition de point de référence définit le point de référence en un point sur la courbe de régression de détérioration, le point étant situé plus tôt d'une valeur prédéterminée qu'une fin d'un segment de données de la pluralité d'états de santé identifiés dans la série chronologique.

3. Système de détermination de détérioration selon la revendication 1 ou 2, comprenant en outre :

une unité d'évaluation de courbe de régression qui évalue la fiabilité de la courbe de régression de détérioration sur la base d'une relation entre la courbe de régression de détérioration et la pluralité d'états de santé servant de base de la courbe de régression de détérioration, dans lequel

lorsque la fiabilité de la courbe de régression de détérioration ne satisfait pas une condition définie, l'unité de détermination de détérioration soudaine évite de déterminer la détérioration soudaine de la batterie secondaire.

4. Système de détermination de détérioration selon l'une quelconque des revendications 1 à 3, comprenant en outre :

une unité de recherche de point prédit qui recherche un point de départ prédit de la détérioration soudaine de la batterie secondaire par le changement dynamique du point de référence, dans lequel

l'unité de détermination de détérioration soudaine détermine la détérioration soudaine de la batterie secondaire sur la base du rapport de pente au point de départ prédit.

5. Système de détermination de détérioration selon la revendication 4, dans lequel

l'unité de génération de courbe de régression génère la courbe de régression de détérioration de la batterie secondaire par la réalisation de la régression de courbe sur la pluralité d'états de santé obtenus avant le point de référence parmi la pluralité d'états de santé de la batterie secondaire qui ont été identifiés dans la série chronologique, et

l'unité de recherche de point prédit définit le point de départ prédit de la détérioration soudaine de la batterie secondaire en un point de convergence d'un point d'intersection entre la courbe de régression de détérioration basée sur la pluralité d'états de santé obtenus avant le point de référence et la ligne de régression de détérioration basée sur la pluralité d'états de santé obtenus après le point de référence.

6. Système de détermination de détérioration selon la revendication 5, dans lequel

l'unité de recherche de point prédit exclut, d'une plage de recherche pour le point de départ prédit, une plage où l'état de santé est supérieur ou égal à une première valeur définie, une plage où la capacité de décharge totale de la batterie secondaire est inférieure ou égale à une deuxième valeur définie, ou une plage où une période d'utilisation de la batterie secondaire est inférieure ou égale à une troisième valeur définie.

7. Système de détermination de détérioration selon l'une quelconque des revendications 1 à 5, dans lequel

lorsqu'un rapport de la pente de la ligne de régression de détérioration suivant le point de référence sur la pente de la ligne tangente à la courbe de régression de détérioration au point de référence dépasse une valeur seuil ou lorsqu'un rapport de la pente de la ligne tangente à la courbe de régression de détérioration au point de référence sur la pente de ligne de régression de détérioration suivant le point de référence chute au-dessous d'une valeur seuil, l'unité de détermination de détérioration soudaine détermine que la détérioration soudaine de la batterie secondaire est survenue.

8. Système de détermination de détérioration selon l'une quelconque des revendications 1 à 5, dans lequel

lorsque le comportement du rapport de pente dans des données en série chronologique du rapport de pente satisfait une condition de détermination générée sur la base d'un apprentissage, l'unité de détermination de détérioration soudaine détermine que la détérioration soudaine de la batterie secondaire est survenue ou qu'un événement précurseur à la détérioration soudaine est survenu.

9. Procédé de détermination de détérioration comprenant :

l'obtention de données de batterie ;
l'identification d'un état de santé (SOH) de la batterie secondaire sur la base des données de batterie ;
la génération d'une courbe de régression de détérioration de la batterie secondaire par la réalisation d'une régression de courbe sur une pluralité d'états de santé de la batterie secondaire qui ont été identifiés dans une série chronologique ;
la définition d'un point de référence sur la courbe de régression de détérioration ;
la génération d'une ligne de régression de détérioration de la batterie secondaire par la réalisation d'une régression linéaire sur la pluralité d'états de santé obtenus après le point de référence, la ligne de régression de détérioration suivant le point de référence ;
le calcul d'un rapport de pente entre une pente d'une ligne tangente à la courbe de régression de détérioration au point de référence et une pente de la ligne de régression de détérioration suivant le point de référence ; et
la détermination d'une détérioration soudaine de la batterie secondaire sur la base du rapport de pente.

10. Support d'enregistrement non transitoire lisible par machine qui stocke un programme de détermination de détérioration qui amène un ordinateur à exécuter les processus de :

l'obtention de données de batterie ;
l'identification d'un état de santé (SOH) de la batterie secondaire sur la base des données de batterie ;
la génération d'une courbe de régression de détérioration de la batterie secondaire par la réalisation d'une régression de courbe sur une pluralité d'états de santé de la batterie secondaire qui ont été identifiés dans une série chronologique ;
la définition d'un point de référence sur la courbe de régression de détérioration ;
la génération d'une ligne de régression de détérioration de la batterie secondaire par la réalisation d'une régression linéaire sur la pluralité d'états de santé obtenus après le point de référence, la ligne de régression de détérioration suivant le point de référence ;
le calcul d'un rapport de pente entre une pente d'une ligne tangente à la courbe de régression de détérioration au point de référence et une pente de la ligne de régression de détérioration suivant le point de référence ; et
la détermination d'une détérioration soudaine de la batterie secondaire sur la base du rapport de pente.

# FIG. 1

# FIG. 2

# FIG. 3

# FIG. 4

# FIG. 5

# FIG. 6

# FIG. 7

# FIG. 8

# FIG. 9

# FIG. 10

# FIG. 11

# FIG. 12

# FIG. 13

```
                        ┌─────────────┐
                        │    Start    │
                        └──────┬──────┘
                               │
        ┌──────────────────────┴──────────────────────┐
  S10   │          Read SOH time-series data           │
        └──────────────────────┬──────────────────────┘
                               │
        ┌──────────────────────┴──────────────────────┐
  S11   │    Generate deterioration regression          │
        │    curve on basis of whole SOH data           │
        └──────────────────────┬──────────────────────┘
                               │
        ┌──────────────────────┴──────────────────────┐
  S12   │             Set reference point A             │
        └──────────────────────┬──────────────────────┘
                               │
        ┌──────────────────────┴──────────────────────┐
  S13   │   Calculate tangent line to deterioration     │
        │   regression curve at reference point A       │
        └──────────────────────┬──────────────────────┘
                               │
        ┌──────────────────────┴──────────────────────┐
  S14   │ Generate deterioration regression line on basis│
        │ of SOH data obtained after reference point A   │
        └──────────────────────┬──────────────────────┘
                               │
        ┌──────────────────────┴──────────────────────┐
  S15   │ Calculate ratio (a/a_tan) of slope of deterioration│
        │ regression line to slope of tangent line      │
        └──────────────────────┬──────────────────────┘
                               │
                          ◇────┴────◇                     N
  S16          ◇   a/a_tan>th ?   ◇─────────────┐
                          ◇─────────◇            │
                               │ Y               │
        ┌──────────────────────┴──────────────┐  │
  S17   │               Issue alert             │  │
        └──────────────────────┬──────────────┘  │
                               │◄─────────────────┘
                        ┌──────┴──────┐
                        │     End     │
                        └─────────────┘
```

# FIG. 14

```
                        ┌──────────┐
                        │  Start   │
                        └──────────┘
                              │
S20  ┌────────────────────────────────────────────────┐
     │            Read SOH time-series data            │
     └────────────────────────────────────────────────┘
                              │
S21  ┌────────────────────────────────────────────────┐
     │        Generate deterioration regression        │
     │        curve on basis of whole SOH data         │
     └────────────────────────────────────────────────┘
                              │
S22  ┌────────────────────────────────────────────────┐
     │        Set initial value of reference point A   │
     └────────────────────────────────────────────────┘
                              │
                              ▼
S23  ┌────────────────────────────────────────────────┐
     │   Generate deterioration regression line on basis │
     │   of SOH data obtained after reference point A   │
     └────────────────────────────────────────────────┘
                              │
S24  ┌────────────────────────────────────────────────┐
     │  Set reference point A to point of intersection between │
     │ deterioration regression curve and deterioration regression line │
     └────────────────────────────────────────────────┘
                              │
S25       ◇ Convergence condition for A satisfied? ◇──── Y
                              │ N
S26  ┌────────────────────────────────────────────────┐
     │  Generate deterioration regression curve on basis │
     │  of SOH data obtained before reference point A   │
     └────────────────────────────────────────────────┘

S27  ┌────────────────────────────────────────────────┐
     │        Calculate tangent line to deterioration  │
     │        regression curve at reference point A    │
     └────────────────────────────────────────────────┘
                              │
S28  ┌────────────────────────────────────────────────┐
     │  Calculate ratio (a/a_tan) of slope of deterioration │
     │  regression line to slope of tangent line       │
     └────────────────────────────────────────────────┘
                              │
S29       ◇      a/a_tan>th ?      ◇──── N
                              │ Y
S210 ┌────────────────────────────────────────────────┐
     │                  Issue alert                    │
     └────────────────────────────────────────────────┘
                              │
                        ┌──────────┐
                        │   End    │
                        └──────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 17098686 A

- JP 6531836 B